Europäisches Patentamt

European Patent Office

Office européen des brevets

(11) Publication number:

**0 320 720**
**A2**

## EUROPEAN PATENT APPLICATION

(21) Application number: 88120178.4

(22) Date of filing: 02.12.88

(51) Int. Cl.⁴: **H05K 7/20 , G06F 1/00**

(30) Priority: 14.12.87 US 133114

(43) Date of publication of application:
21.06.89 Bulletin 89/25

(84) Designated Contracting States:
**CH DE ES FR GB IT LI**

(71) Applicant: **Siemens Aktiengesellschaft Berlin und München**
**Wittelsbacherplatz 2**
**D-8000 München 2(DE)**

(72) Inventor: **Klein, Klaus**
**Kirchbühl 3**
**D-7512 Rheinstetten 1(DE)**

(54) **A non-stop cooling system for a computer.**

(57) A non-stop cooling system is provided for a computer system. The cooling system uses two fans both normally operating at reduced capacity to cool the system. A failure of one fan causes the other fan to operate at full capacity to cool the system. Each fan forces air through a door which closes when the associated fan fails allowing the failed fan to be removed without shutting down the system.

FIG 1

EP 0 320 720 A2

# A NON-STOP COOLING SYSTEM FOR A COMPUTER

## Background of the Invention

This invention relates generally to a computer system and more particularly to a cooling system for ventilating the computer.

Computers are machines with contain numerous parts including parts which are subject to periodic or random failure. Since it appears inevitable that at some time a system, sub-system or component will fail, it is prudent to increase the time between failures as much as is practical. The greater the meantime between failures, the greater the reliability of the computer. Accordingly, it will be appreciated that it is highly desirable to have a computer system which has a very high meantime between failures.

While much is being done to increase the meantime between failures, much is also being done to decrease the amount of space that a computer system occupies. Thus, with the shrinking of components and overall computer size, more components are being fit into a decreasing amount of space. This move has been greatly aided by micro-electronic circuitry and micro-chips. While the micro-chips generally consume less power the packaging density on the boards has been increased drastically; on top of that sandwich-mounted modules on base boards require a reliable cooling system with adequate air velocity than the old vacuum tubes and discreet components of the past, nevertheless, they still generate heat and must be provided with proper ventilation and cooling for reliable operation.

In the past, the amount of cooling required for a particular computer system has been computed and a cooling system designed to meet those needs. It is not uncommon, however, to have to shut down a computer system when the cooling system fan needs maintenance or when the fan fails causing the fan to be a limiting factor in maximizing mean time between failures. It is not uncommon for the fan and computer system to run continuously whenever the computer is operating and for some time after the computer is turned off so that the circuit boards do not overheat.

Understandably, it is desirable to operate today's expensive computer system on a 24-hour a day basis or to utilize such a computer as much as possible. One of the last things that one would want is to have to shut down operation of the computer because of a failure of the cooling system. Yet, cooling system failure is not uncommon. Accordingly, it can be appreciated that it would be highly desirable to provide a cooling system for a computer which has a very large meantime between failures and which is not a limiting component of the computer. It is desirable to have a cooling system which runs non-stop and the failure of a component of which will not disable the complete cooling system. Further, such a cooling system should be compact and economical.

Accordingly, it is an object of the present invention to provide a cooling system for a computer which provides adequate cooling for the computer system and which has a large meantime between failures with low andible noise level at normal operation.

Another object of the invention is to provide a cooling system which operates non-stop and which can undergo partial failure without endangering the components of the computer system allowing online repair of the failing autonomous blower unit. Also, the failure in a blower unit needs to be detected immediately leading to the automatical switch to full speed of the operating blower unit and reporting the failure to the system.

Still another object of the present invention is to provide a cooling system which is simple and economical.

## Summary of the Invention

Briefly stated, in accordance with one aspect of the invention, the foregoing objects are achieved by providing a non-stop cooling system. The cooling system includes first and second fans each producing an outward air flow and means for sensing cessation of output air flow or pressure. The cooling system includes means for automatically increasing the outward air flow of one of the fans in response to cessation of the air flow of the other fan.

By having two fans, the meantime between failures is increased and one fan can be in use while the other is being serviced or repaired. By having one fan produce enough output to keep the computer system at a predetermined temperature, there is never any danger of the computer system overheating due to the failure of just one fan. Also, when both fans are operating, neither has to be operated at 100 % capacity thereby increasing the life of each fan making the cooling system economical and less noisy.

The mentioned sensor means, e. g. the pressure sensors, reports a failure to the control means for switching the operating blower unit to full speed.

In case of a failure, the blower units are autonomous and designed to be exchanged easily. It is easily to diconnect the blower unit from the power card by one plug and mechanicly from the computer housing by loosing one screw.

Air inlet openings infront of each blower unit are covered with moving multiple flaps. These flaps are designed that they will be closed automatically by the pressure generated by the operating blower unit for preventing an air-short circuit. For that no special control means and mechanics are required.

## Brief Description of the Drawings

While the specification concludes with claims particularly pointing out and distinctly claiming the subject matter which is regarded as the invention, it is believed that the invention will be better understood from the following description of the preferred embodiment taken in conjunction with the accompanying drawings in which:

Fig. 1 is a diagrammatic isometric view of a computer system incorporating the cooling system of the present invention illustrating the air intake, fan housing, air exhaust, air plenum and sensor means;

Fig. 2 is a diagrammatic view showing the arrangement of the cooling fans and control unit plus online repair directions; and

Fig. 3 and Fig. 4 are showing different types of the air exhaust in greater detail.

## Description of a Preferred Embodiment

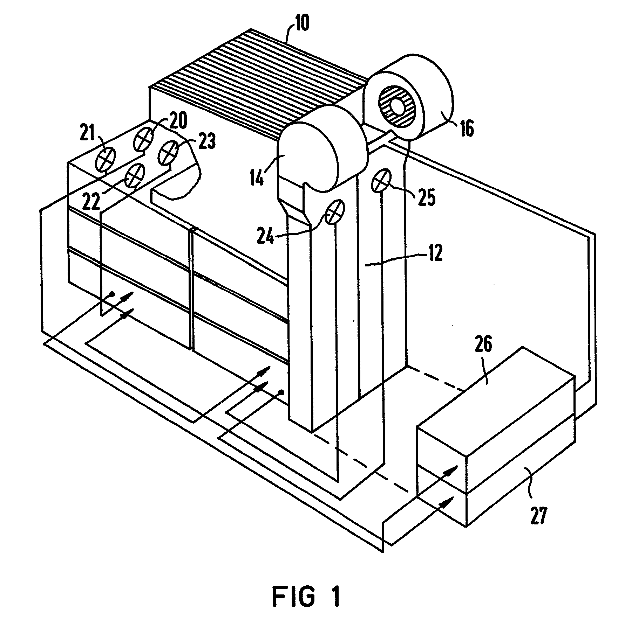

Referring to Fig. 1, a computer system has a housing 10 which encloses the internal circuit boards and other computer components and which has an air inlet for receiving air for ventilation and cooling and it has an air outlet for exhausting air from the housing which has been circulated through an air plenum for two blower units with air distribution guides from the air inlet to the air outlet thereby cooling the internal computer components.

An air plenum 12 is positioned adjacent the housing 10. The air plenum 12 has one or more openings which align with the air outlet openings for receiving the air once it has circulated through the housing 10. The air plenum has one or more outlets through which the air is passed to another component or unit for cooling in serial the cooling system provides fans 14 and 16 and sensor means 20 ... 25 which monitors the detected failures to the computer system and to switching circuits 26 and 27.

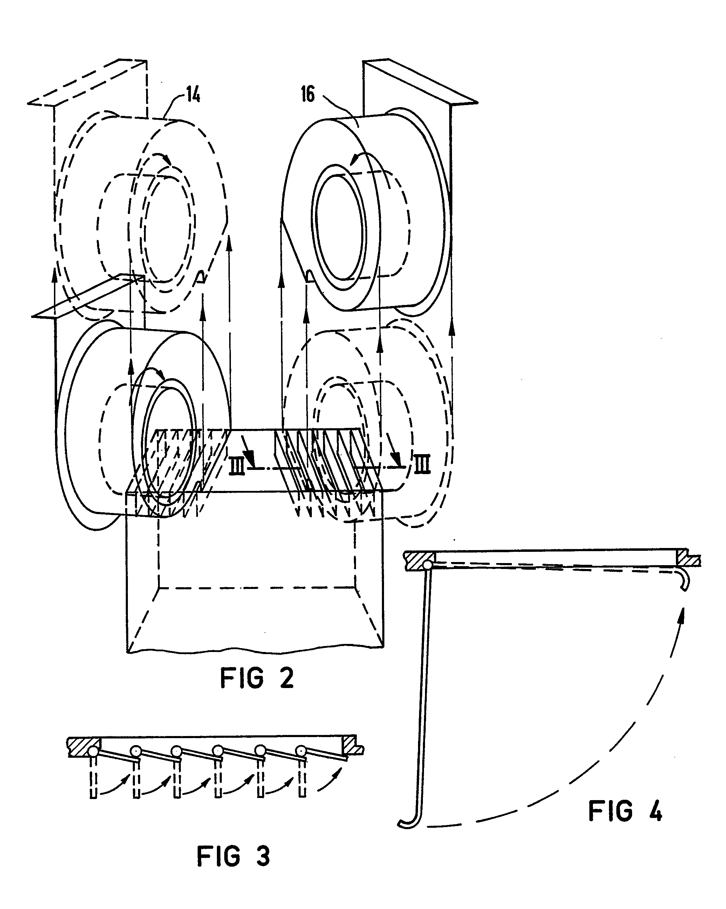

Referring to Fig. 2, the cooling system includes the two cooling fans 14 and 16 which may be axial or radial fans as are well known in the art. When operating, each fan takes in air, accelerates it and exhausts it into the computer housing 10. The exhaust air of each fan passes through an exhaust port or opening. Each port or opening preferably has a set of flaps which is hingedly connected to the inlet of the plenum which is held open by the pressure of the air flow eminating therefrom. When air flow ceases, the flap falls by the pressure of the operating blower and closes the opening or the flap may be spring assisted to ensure positive closing. By this construction, one fan can be removed while the other fan operates without interfering with the flow of air. Under normal circumstances, both fans operate at reduced capacity. In case of blower unit failure the sensor means, e. g. pressure sensors, detects the fault and activates the control means for switching the operating blower unit to full speed. The sensor means are able to monitor the failure to the computer system for announcing this to the system operator. If one fan operates alone, it is operated at 100 % of the rated capacity which provides sufficient air flow to the computer to control the computer temperature within prescribed limits.

The air flow of the fans is controlled by adjusting the fan rotational speed. The switching circuits are used to change the fan speed. The switching circuits 26, 27 changes fan speed in response to a signal which is received from the sensor associated with each fan. An air flow sensor, for example, might consist of a micro-switch or preferable of a pressure sensor which is actuated when the flap closes. Closure of the flap would indicate that there is no air flow to keep it open and will alert the control unit to increase the air output of the other fan.

In operation, under normal conditions, fans 14 and 16 operate at a reduced capacity, e. g. 70 %, circulating air through the computer housing 10. The air flow forces the flaps open and the micro-switches/pressure sensors inactivate. Upon the sudden failure of one of the motors, the associated flap will close activating the micro-switch/pressure sensor which alerts the control unit 18 that one of the fans has failed. The control unit then increases the output of the remaining operating fan from 70 % of its rated capacity to 100 % of its rated capacity thereby insuring that the minimum air flow required to keep the computer within the prescribed temperature limits is maintained. Since each motor can provide 100 % of the air flow required to keep the computer system within the prescribed temperature limits, the system can run indefinitely on a single fan. This being the case, routine or periodic maintenance on the fans is greatly simplified. Routine maintenance can be performed by simply removing a fan which causes the flap by disonnecting the power plug and one screw to close operating the micro-switch/pressure sensor which alerts the control unit that the air flow has ceased whereupon it increases the output of the remaining fan to 100 % of capacity. In this manner, maintenance can be scheduled at convenient times without having to shut the system down.

It will now be understood that there has been disclosed a non-stop cooling system for a computer which uses two fans thereby greatly increasing the meantime between failures. Each fan is capable of supplying 100 % of the air flow required to keep the computer operating within prescribed temperature limits thereby insuring that it is never necessary to shut the system down because of the failure of one fan. The use of two fans greatly simplifies scheduling computer maintenance. It is also seen that during normal operation, since each fan operates at only 70 % capacity, the life of each fan is greatly increased thereby making the non-stop system a long term economical system.

As will be evident from the foregoing description, certain aspects of the invention are not limited to the particular details of the examples illustrated, and it is therefore contemplated that other modifications or applications will occur to those skilled in the art. For example, there are other ways of sensing the air flow other than using the simple flap and simple micro-switch, e. g. air flow or pressure sensor. It is accordingly intended that the claims shall cover all such modifications and applications as do not depart from the true spirit and script of the invention.

## Claims

1. A non-stop cooling system for a computer of the type having a housing with an air inlet, an air outlet and a passageway from the air inlet to the air inlet, comprising:
an air plenum adjacent the housing having openings aligned with the air outlet;
first and second variable air flow fans adjacent the housing having an air intake and an air exhaust, said air exhaust being aligned with the housing air inlet; and
a control unit for automatically, controllably varying the air flow of said first and second fans.

2. A non-stop cooling system according to claim 1, wherein the control unit varies the air flow of each fan.

3. A non-stop cooling system according to claim 1, wherein the control unit varies the air flow of each fan by varying the rotational speed of each fan.

4. A non-stop cooling system according to claim 1, wherein the rated air flow of each fan is at least equal to the minimum air flow demand of the computer.

5. A non-stop cooling system according to claim 4, wherein each fan normally produces a reduced rate of its air flow.

6. A non-stop cooling system according to claim 5, wherein the control unit monitors the air flow or pressure of each fan and operates one fan at 100 % of its rated air flow in response to sensing a loss of air flow from the other fan.

7. A non-stop cooling system according to claim 1, wherein first and second fans are enclosed in a common housing.

8. A non-stop cooling system according to claim 7, wherein the air plenum is adjacent the common fan housing.

9. A non-stop cooling system according to claim 1, wherein the air exhaust of each fan has an air flow sensor.

10. A non-stop cooling system according to claim 9, wherein the air flow sensor includes a micro-switch, and flaps positioned over the air exhaust and movable between a closed position at the flaps abuts the micro-switch and an open position at which the flaps are free of contact with the micro-switch, said flap being held in the open position by exhaust air flow and moving to the closed position in response to cessation of air flow and actuating the micro-switch which alerts the control unit that air flow has ceased.

11. A non-stop cooling system comprising:
first and second fans each producing an output air flow;
means for sensing cessation of output air flow; and
control means for automatically increasing the output air flow of one of said first and second fans in response to cessation of air flow of the other of said first and second fans.

12. A non-stop cooling system according to claim 1, wherein the control means varies the air flow of each fan by varying the rotational speed of each fan.

13. A non-stop cooling system according to claim 9, wherein each fan has an exhaust duct and the sensing means includes a micro-switch, and flaps positioned over the duct and movable between a closed position at the flap abuts the micro-switch and an open position at which the flap is free of contact with the micro-switch, said flap being held in the open position by output air flow and moving to the closed position in response to cessation of air flow and actuating the micro-switch.

14. A non-stop cooling system according to claim 1, wherein the fans are mounted with one screw inside the computer housing and connected with one power plug to the power supply.

15. A non-stop cooling system according to claim 1, wherein the air plenum is distributing the amount of the air flow velocity adjacent to the need of the particular system modules which have to be cooled.

FIG 1

FIG 2

FIG 3

FIG 4